# EUROPEAN PATENT SPECIFICATION

(11) **EP 3 387 482 B1**
(45) Date of publication and mention of the grant of the patent: **16.11.2022**
(21) Application number: 16872494.6
(22) Date of filing: 18.07.2016
(51) Int. Cl.: G02B 27/00, C23C 14/54, G01B 11/06, G01B 11/00, G01B 11/24, C23C 14/28

(54) **SYSTEM AND METHOD FOR MONITORING OF SURFACE PROFILE AND THICKNESS MEASUREMENT IN THIN FILMS**
SYSTEM UND VERFAHREN ZUR ÜBERWACHUNG EINES OBERFLÄCHENPROFILS UND DICKENMESSUNG IN DÜNNSCHICHTEN
SYSTÈME ET PROCÉDÉ DE SURVEILLANCE DE PROFIL DE SURFACE ET DE MESURE D'ÉPAISSEUR DANS DES COUCHES MINCES

(30) Priority: 12.12.2015 IN 4088DE2015
(43) Date of publication of application: 17.10.2018
(73) Proprietor: Secretary, Department of Electronics and Information Technology (Deity), New Delhi 110003 (IN); Indian Institute of Technology, Guwahati, Guwahati, Assam 781039 (IN)
(72) Inventor: BORUAH, Bosanta, Ranjan, Guwahati Assam 781039 (IN); KHARE, Alika, Guwahati Assam 781039 (IN); PATHAK, Biswajit, Guwahati Assam 781039 (IN); KESARWANI, Rahul, Guwahati Assam 781039 (IN)
(74) Representative: Murgitroyd & Company
(86) International application number: PCT/IB2016/054261
(87) International publication number: WO 2017/098343

(56) References cited:
- WO-A1-2006/027568
- US-A1- 2002 012 122
- US-A1- 2014 232 855
- US-B1- 8 384 999
- B R Boruah: "Zonal wavefront sensing using an array of gratings", Optics letters, 15 January 2010 (2010-01-15), pages 202-204, XP055637717, United States DOI: 10.1364/OL.35.000202 Retrieved from the Internet: URL:https://www.osapublishing.org/DirectPD FAccess/2669976C-A389-99CA-1E504E971EDE1F2 5_194963/ol-35-2-202.pdf?da=1&id=194963&se q=0&mobile=no

## Description

### TECHNICAL FIELD

The present subject matter described herein, in general, relates to the field of deposition of thin film. The invention relates more specifically to simultaneous in-situ real-time monitoring of surface profile and thickness measurement of the said thin film using a grating array based wavefront sensor during growth process.

### BACKGROUND

The surface profiling and the thickness of the thin film are very important parameters for any device utilizing the thin films such as optical components, semiconductor devices, miniaturized sensors etc. Therefore, these parameters are required to be monitored at different instants of time. The properties of the thin film can be tailored during the growth process if these parameters are monitored in-situ in real time.

The non-intrusive in-situ technique of surface profiling and the thickness monitoring are very important for any device utilizing the thin films such as optical components, semiconductor devices, miniaturized sensors etc. The properties of the thin film is tailored during the growth process if these parameters are monitored in real time, in-situ and non- intrusively.

Accordingly, the in-situ techniques that are available in the art for monitoring the growth of the thin films is categorized in two ways; intrusive and non-intrusive techniques.

The most commonly available intrusive technique for monitoring the thickness of the thin film is Quartz crystal balance. Reference is made to a non-patent literature, P.F. Jaeger, W.H. Smyrl, NACE, paper No. 626, 1996 (http://www.nace.org/cstm/Store/Product.aspx?id=92cel 553-62 I l-4eel-b5c0- 03a2cb753alb); X. Du, Y. Du, S.M. George, J. Vac. Sci. Tech. A, 23 (4), 581-588, 2005 (www.colorado.edu/chemistry/GeorgeResearchGroup/pubs/230.pdf). However, in quartz crystal balance, the thin film is deposited on the surface of the quartz crystal. With the growth of the film, the natural frequency of vibration of crystal changes, which is related to the mass of the material deposited and hence for the known area film thickness is determined. This is not directly in-situ process as here the thin film deposition takes place on the surface of quartz and not on the actual substrate. This technique is not useful for thicker films as the crystal will stop oscillating if a large amount of mass is deposited onto the quartz crystal. Moreover the natural frequency of oscillation of the Quartz crystal is sensitive to temperature and stress changes which indirectly brings some inaccuracy to the thickness measurement while depositing on the actual substrate.

Another existing variant of the quartz crystal is ultrasonic quartz lamb wave. Reference is made to a non-patent literature, Jun Pei, F.L. Degertekin, B.V. Honein, B.T. Khuri-Yakub and K.C. Saraswat, IEEE Ultrasonics Symposium, 1051-0117/94/0000, 1237 1240, 1994 (http://www-kyg.stanford.edu/khuriyakub/opencms/Downloads/94_Pei_01.pdf). Reference is also made to US patent No. 6,019,000, wherein ultrasonic quartz lamb wave is utilized in thin film analysis. However, in this technique deposition takes place on the quartz crystal only. The quartz crystal acts as an acoustic sensor. The technique is based on the fact that the velocity of the ultrasonic lamb wave traveling in quartz changes with the growth of the thin film on it. This technique requires the prior knowledge of the substrate acoustic properties and is also dependent on the temperature of the substrate. Due to these shortcomings, this technique has hardly been used.

Another intrusive technique is based on the optical fibre as a sensor. Reference can be made to non-patent literature, Y.C. Tsao, W.H. Tsai, W.C. Shih and M.S. Wu, Sensors, 13, 9513-9521, 2013 (http://www.ncbi.nlm.nih.gov/pubmed/23881144); D. Jose, M.S. John, P. Radhakrishnan, V.P.N. Nampoori, C.P.G. Vallabhan, Thin Solid Film, 325, 264-267,1998(www.researchgate.net/...thin_films/.../541bf4640cf203fl55b34672.pdf. This technique utilizes the surface plasmon properties of the core-cladding interface of the fibre. This technique is implemented by removing the cladding from the fibre and the film is allowed to grow on the uncladded region of the fibre. Due to the replacement of the cladding material with the material of the deposited thin film, the propagation of the laser through the fibre under goes enhanced absorption due to surface plasmon resonance (SPR) which can be detected at the other end of the fibre and is related to the film thickness. However, this technique is also limited to the lower thickness level only, as at higher thicknesses, absorption becomes independent of thickness. Moreover, this technique is applicable to those materials only which exhibit strong SPR property and also the deposition takes place on the fibre and not on the actual substrate.

Thus, in all the above mentioned intrusive techniques, the thin film deposition takes place on the transducer rather than on the actual required substrate and this leads to a large degree of inaccuracy while assessing the thickness and the profile of thin film in the actual situation. Also all of these techniques are restricted to the measurement of average thickness only and not suitable for the surface profiling. In case of the non-intrusive techniques, thin film is directly deposited on the substrate. Among the available non-intrusive techniques, ellipsometry is more commonly implemented to monitor the average thickness of the film during the growth process. Reference can be made to non-patent literature, S.A. Henck, W.M. Duncan, J M. Loewenstein, and J. Kuehne, Proc. SPIE, 1803, 1992 (http://proceedings.spiedigitallibrary.org/proceeding.aspx?articleid= 1001800); J. H. Gruenewald, J. Nichols, and S. S. A. Seo, Rev. Sci. Instrum. 84, 043902, 2013 (http://arxiv.org/abs/1302.5074). However, the ellipsometric technique is based on the polarization dependent reflectivity of the film-substrate system. In this technique, a tunable optical source illuminates the film at a point and the polarization of the reflected light is recorded as a function of wavelength and angle of incidence which is then related to the thickness of the film, provided the optical properties of the substrate and the refractive index of the film are known. The refractive index of the film depends on the thickness as well as the substrate and the deposition environment that includes but not limited to temperature and the gas pressure. Thus, the technique requires a prior calibration for each and every environment under which film is deposited and the substrate on which deposition is taking place. Further, being a point measurement technique it does not provide the entire surface information at one instant.

Another simple variant of ellipsometry is the reflectometry, where reflectivity of the sample is measured as a function of wavelength and then fitted to the suitable equations to determine the thickness of the film. Reference is made to U.S. Patent No. 6,525,829. However, the accuracy of this technique depends on the reflectivity of the film and thus is restricted to only highly reflecting films. Similar to ellipsometry, this technique also requires the prior information about the substrate and refractive index of the film, besides being a point measurement technique.

Another available non-intrusive technique is interferometry. In-situ thickness measurement is performed either by spectral interference of the light emitted from the plasma near the top and the bottom surfaces of the film at the grazing incidence during deposition or by recording the interference pattern by an external laser source falling on the film surface. Reference is made to U.S. Patent No. 6,888,639 B2 and U.S. Patent No. 5,450,205. The U.S. Patent No. 6,888,639 B2 is limited to the deposition system involving the bright plasma whereas the U.S. Patent No. 5,450,205 requires the recording of a sequence of images using an array detector over a certain time interval. Thus, the U.S. Patent No. 5,450,205 suffers from inherent minimum acquisition time for each measurement. Further, the intensity in the image on the detector plane for a certain wavelength of radiation will also be a function of properties of the thin film material. Besides these conventional techniques in thin film deposition system, there exists approaches wherein thin film metrology is analyzed using wavefront sensors. Reference is made to US patent number 5,563,709, wherein a metrology apparatus comprising Hartmann- Shack wavefront sensor that uses a binary optic lenslet array to obtain total thickness variations of wafer for thinning and flattening of wafers. However, the binary optic lenses do not provide the flexibility of the grating array based wavefront sensor proposed here. Moreover, the fixed geometry of the lenslets array results in a fixed geometry of the focal spot array that makes it essential to use same number of rows and columns of the detector array resulting in limited frame rate of the detector like CCD or CMOS camera used. In another arrangement, reference is made to patent number WO 2006027568 and EP patent number 1789753A1, wherein a technique for real time thin film thickness and relative tilt measurement is disclosed by analyzing numerous output electromagnetic fields from numerous surfaces of the thin film. The wavefront sensor employed for the process is a phase diversity wavefront sensing technique where the wavefront is estimated from the derivative of its intensity. Further, the patent reference suggests the use of a wavefront sensor to measure the wavefront corresponding to the two surfaces of the thin film. However, these references does not mention about the grating array based wavefront sensing which not only measures the said two wavefronts but also measures them at the highest possible frame rate of the detector array. Further, the thickness measurement takes place at one point of the sample only and requires mechanical scanning of the beam in order to measure the thickness over different points on the sample, thus the recording of the complete profile at any given instant of time is not possible.

In another arrangement, wavefront sensing principle was used for in-situ real time measurement of thin film thickness. Reference is made to non-patent literature, D. M. Faichnie, I. Bain, A. H. Greenaway, Proc. SPIE 60180T, 2005 and D. M. Faichnie, A. H. Greenaway, K. Karstad and I. Bain, J. Opt. A: Pure Appl. Opt. 7, S290-S297, 2005, based on reflections from each of the thin film deposited interfaces. Thin film thickness is measured from the difference in the reflected images captured in the detector plane. However, the technique requires a series of measurements at different instants of time to gather the information over the entire thin film as it provides information at a specific point on the sample only. Besides these drawbacks in the available techniques as mentioned above, in-situ monitoring of the thin film growth process primarily focuses on bulk properties of the sample such as thickness, while the surface profiling is usually done by using ex-situ techniques. Further, the reported technologies that provide information related to the in-situ surface profiling, require prior information regarding the properties of the material of thin film and the substrate on which film is grown. Furthermore, the conventional techniques are restricted to only some specific type of films or are dependent on the environment of deposition or the substrate properties, thus requiring the prior calibration every time while changing the deposition conditions. Moreover, the available techniques either provide the average thickness or the surface profile only.

There are also certain available techniques that provide in-situ surface profiling. However, the same techniques involve serial processing and require prior spatial information regarding the sample. Thus, in such techniques the surface profile is constructed using spatial information received at different instants of time. Besides, the wavefront sensor usually measures the surface profile from the wavefront of the reflected beam from the substrate. However, mechanical vibrations in the deposition system add inaccuracies in the measurement unless the sensing frame rate is high enough to reduce the effect of vibrations. Therefore, to the best of our knowledge there is no single technique that is available which can cater both the parameters, i.e. surface profiling and thickness monitoring simultaneously on-line, independent of the choice of the environment and the material of thin film and substrate.

Reference is also made to non-patent literature, B. R. Boruah, Optics Letters 35(2), 202-204, 2010, which discloses working of a grating array based zonal wavefront sensor. Further, reference is also made to non-patent literature, B. R. Boruah and A. Das, Applied Optics 50(20), 3598-3603, 2011, which discloses about how the spatial frequencies of the grating elements can be defined so that the diffracted beams can be focused to form focal spot arrays with user defined number of rows and columns. Furthermore, with reference to non-patent literature, W. H. Southwell, Journal of Optical Society of America 70(8), 998- 1006, 1980 and B. Pathak and B. R. Boruah, Journal of Optics 16(5), 055403, 2014, standard or improved wavefront reconstruction algorithm can be employed to reconstruct the incident wavefront. However, it is seen that none of the cited journals reveals that the grating array based wavefront sensor can be used in a thin film deposition system. Besides, it does not teach about simultaneous measurement of thickness and surface profile in a thin film system using a grating array based wavefront sensor. Further, none of the patent or non patent literature teaches to measure the surface profile for non-planar substrate or to measure the thickness and surface profile of thin films separately or simultaneously with enhanced sensitivity.

Thus, in view of the drawbacks of the existing techniques as discussed above, it can be ascertained that there is no single technique that is available which can cater both the parameters, i.e. surface profiling and thickness monitoring simultaneously on-line during the growth process ( irrespective of the growth environment and the properties of substrate). Therefore, there exists a dire need to provide an in-situ real time monitoring of surface profiling and thickness measurement of thin films that overcomes the drawbacks of the conventional techniques.

### SUMMARY

The following presents a simplified summary of the invention in order to provide a basic understanding of some aspects of the invention. This summary is not intended to identify essential features of the claimed subject matter nor is it intended for use in determining or limiting the scope of the claimed subject matter. Its sole purpose is to present some concept of the invention in a simplified form as a prelude to a more detailed description of the invention presented later.

The main objective of the present invention is to provide a system that utilizes grating array based wavefront sensor for simultaneous in-situ real-time monitoring of surface profiling and thickness measurement of thin films in thin film deposition unit.

Another object of the present invention is to use a programmable light modulator to implement grating array based wavefront sensor in the thin film deposition system.

Yet another object of the present invention is to provide programmable switching between various grating patterns in the light modulator, to measure both the surface profile and/or thickness of the thin film.

Still another object of the present invention is to provide real time monitoring of the surface profile and the thickness measurement simultaneously of thin films without any requirement of prior calibration, thus making it independent of the substrate, material of the thin film and the deposition environment.

According to a first aspect of the present invention there is provided a system as claimed in Claim 1.

According to a second aspect of the present invention there is provided a method as claimed in Claim 14.

Other aspects, advantages, and salient features of the invention will become apparent to those skilled in the art from the following detailed description, which, taken in conjunction with the annexed drawings, discloses exemplary embodiments of the invention.

### BRIEF DESCRIPTION OF THE ACCOMPANYING DRAWINGS

The above and other aspects, features, and advantages of certain exemplary embodiments of the present invention will be more apparent from the following description taken in conjunction with the accompanying drawings in which:
Figure 1 is an illustration of one embodiment of a system to monitor both the surface profile and thickness of the thin film simultaneously, according to first implementation of the present invention.
Figure 2 is an illustration of the system wherein two lenses L5 and L6 are positioned between the substrate and the programmable mask, according to second implementation of the present invention.
Figure 3 is an illustration of the working of a grating array based zonal wavefront sensor, according to all implementation of the present invention.
Figure 4 is an illustration of an example wherein monitoring of the surface profile and thickness of the thin film can be realized in a pulsed laser deposition system for thin films simultaneously, according to all implementation of the present invention. Figure 5 is an illustration of a system to simultaneously monitor both the surface profile and thickness of the thin film, according to third implementation of the present invention if the surface of the substrate is uneven.
Figure 6 is an illustration of a system to simultaneously as well as separately monitor both surface profile and thickness of the thin film, according to the fourth implementation of the present invention.

Persons skilled in the art will appreciate that the elements in the figures are illustrated for simplicity and clarity and may have not been drawn to scale. For example, the dimensions of some of the elements in the figure may be exaggerated relative to other elements to help to improve understanding of various exemplary embodiments of the present disclosure. Throughout the drawings, it should be noted that like reference numbers are used to depict the same or similar elements, features, and structures.

### DETAILED DESCRIPTION OF THE PRESENT INVENTION

The following description with reference to the accompanying drawings is provided to assist in a comprehensive understanding of exemplary embodiments of the invention. It includes various specific details to assist in that understanding but these are to be regarded as merely exemplary.

Accordingly, those of ordinary skill in the art will recognize that various changes and modifications of the embodiments described herein can be made without departing from the scope of the invention as defined by the claims. In addition, descriptions of well-known functions and constructions are omitted for clarity and conciseness.

The terms and words used in the following description and claims are not limited to the bibliographical meanings but are merely used by the inventor to enable a clear and consistent understanding of the invention. Accordingly, it should be apparent to those skilled in the art that the following description of exemplary embodiments of the present invention are provided for illustration purpose only and not for the purpose of limiting the invention as defined by the appended claims and their equivalents. It is to be understood that the singular forms "a," "an," and "the" include plural referents unless the context clearly dictates otherwise.

By the term "substantially" it is meant that the recited characteristic, parameter, or value need not be achieved exactly, but that deviations or variations, including for example, tolerances, measurement error, measurement accuracy limitations and other factors known to those of skill in the art, may occur in amounts that do not preclude the effect the characteristic was intended to provide.

Features that are described and/or illustrated with respect to one embodiment may be used in the same way or in a similar way in one or more other embodiments and/or in combination with or instead of the features of the other embodiments.

It should be emphasized that the term "comprises/comprising" when used in this specification is taken to specify the presence of stated features, integers, steps or components but does not preclude the presence or addition of one or more other features, integers, steps, components or groups thereof.

The objects, advantages and other novel features of the present invention will be apparent to those skilled in the art from the following detailed description when read in conjunction with the accompanying drawings.

The present invention achieves the objective by utilizing a grating array based a wavefront sensor in a Pulsed laser deposition of thin film system or any other appropriate thin film deposition system. The data processing module is configured to measure wavefront of the incident beam by monitoring surface profile of a sample such as a substrate, thin film and thickness measurement of the thin film. The solution of the present invention is found to be one of the most appropriate ways with which one or more of the mentioned problems are addressed without having any shortcomings associated with the prior arts. It is to be understood, that those having specific knowledge and skill in the related field may recognize additional modifications, however coming up with an alternative solution other than involving a grating array based wavefront sensor is not seen feasible.

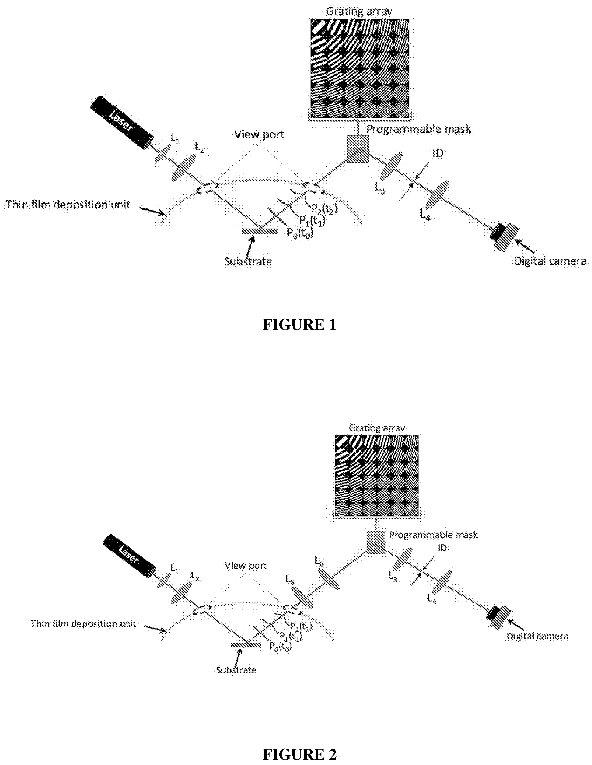

In one implementation, the grating array based wavefront sensor device can be a zonal wavefront sensor or any alternative of the zonal wavefront sensor. Reference is made to figure 1, wherein a system to simultaneously monitor both the surface profile and thickness of the thin film is illustrated, according to first implementation of the present invention.

Reference is made to figure 2, wherein a system having two lenses L5 and h positioned between the substrate and the programmable mask is illustrated, according to second implementation of the present invention.

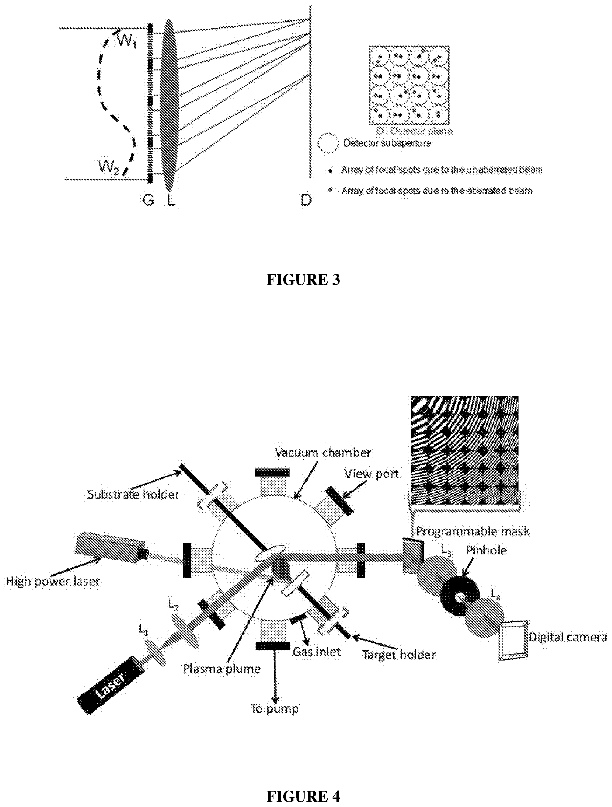

Reference is made to figure 3, wherein the working of a grating array based zonal wavefront sensor is illustrated, according to all implementation of the present invention.

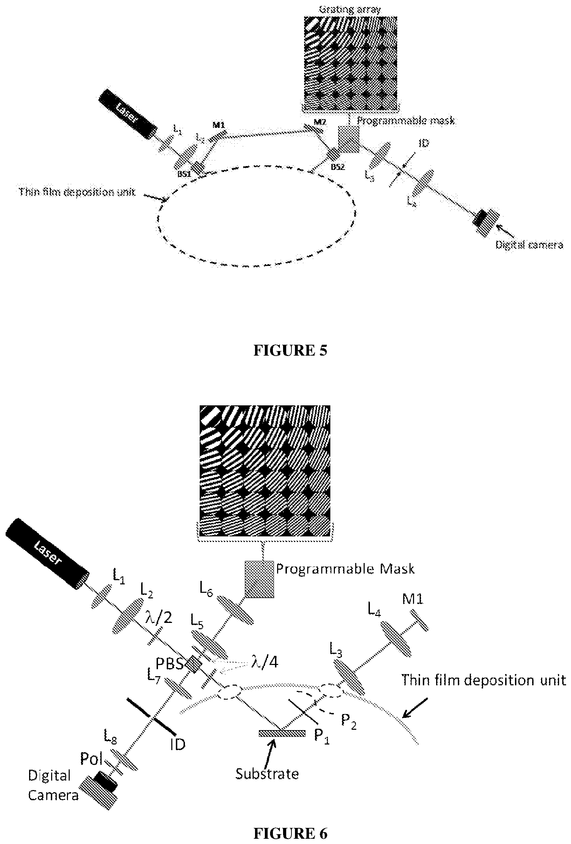

In the first and second implementation, as shown in figure 1 and figure 2 and in the third and fourth implementation, as shown in figure 5 and figure 6, a collimated laser beam may be directed on to the substrate on which thin film is deposited and the reflected beam may be directed towards a grating array based zonal wavefront sensor. The zonal wavefront sensor measures wavefront of the incident beam at any instant of time relative to the beam getting reflected from the substrate prior to the commencement of deposition. The sensor measures the wavefront from the information regarding focal spot positions corresponding to at least one relative position of the focal spot array before deposition and at any subsequent instants during or after deposition from the various elements in the grating array.

In all the implementations, the collimated laser beam can enter the thin film deposition system through a view port of the deposition chamber and can be incident on the substrate on which deposition is to take place. The reflected beam comes out through another view port suitably located on the chamber and is then incident on a grating array based zonal wavefront sensor. The zonal wavefront sensor provides the information regarding surface profile in terms of a reconstructed wavefront of the incident beam or magnitudes of the aberration modes corresponding to an orthogonal basis function. If the measurement starts from the moment when there is no deposition, the sensor can provide a measure of both surface profile and thickness simultaneously, provided the measured area over the substrate is larger than the area over which deposition is taking place. The configuration of the grating array provides additional tools for thickness measurement even if the measured area is smaller and also compensate for the mechanical vibrations in the system.

Moreover, in all the implementations, the reflected beam wavefront can be measured from the focal spot positions corresponding to different portions of the wavefront taken at a given instant of time. Thus, the wavefront measurement process is inherently parallel in nature. The grating array sensor may be implemented using a programmable and reconfigurable device such as a spatial light modulator (SLM). Such a device may facilitate a dynamic replacement of the grating array by a single hologram which allows measurement of thickness of the thin film locally or globally even though the film deposition is taking place over an area greater than the measured area. The programmable nature of the grating array based wavefront sensor may also facilitate operating of the digital camera attached to the sensor to work at its highest possible frame rate. Thus in the proposed invention, the measurement will be least affected by the mechanical vibrations present in the reflected beam due to the vibration in the deposition system. Thus, in all implementation, the principle behind the surface profiling is independent of the beam intensity and hence the reflectivity of the thin film. If the measured area is larger than the area over which thin film is grown, the surface profiling may also be accompanied by the thickness profile. Thus both the surface profiling and the thickness can be obtained without having the information regarding global or local variation in the properties of the thin film material over the whole measured area.

In first implementation, the arrangement illustrated in figure 1, monitors both the surface profile and thickness of the thin films during deposition in a thin film deposition unit. To monitor the real time growth of the thin films, a combination of two lenses Li and L2 can be used to expand and collimate a laser beam that enters the deposition unit. The collimated beam is incident on the substrate on which deposition may take place and the reflected beam from the substrate can be then incident on the array of gratings of the grating array based zonal wavefront sensor as shown in figure 3. The array of gratings can be implemented using a programmable amplitude or phase mask that can be controlled by means of a user interface (PC interface). The diffracted beams of a certain desired order from the gratings may be focused on a digital camera with the help of the lens combination L3 and L4 and an iris diaphragm ID, to form an array of focal spots whose positions are thereby read by computer program of the said sensor. In second implementation of the system as shown in figure 2, two lenses, L5 and L6 are kept in between the substrate and the mask such that the two planes are made optically conjugate to one another.

In all implementation, the working of the grating array based wavefront sensor is shown in figure 3. The grating array may be constructed such that each of the grating element has a circular aperture of equal diameter and a square wave transmittance profile, i.e. amplitude transmittance varies by 0 or 1 , or - 1 or 1. Light beam which may be incident on the grating array gets diffracted and are focused by the lens L onto the detector plane D resulting in 0, ±1, ±3,... diffraction orders at relative positions 0, ±1, ±3,... with respect to the position of the un-diffracted zero order. The separation of the ηω order with respect to the zero order is dependent on the diffraction order and on the spatial frequencies (representing periodicity and orientation of the grating rulings) corresponding to the square wave pattern in the grating. Thus, suitably choosing the spatial frequency of each grating, the focal spots corresponding to ηω diffraction order can be made to form a regular array or arrays in the case of an unaberrated incident beam.

In one implementation, for a 2D array of square wave amplitude gratings having dimensions NxN, the index i represents the rows and index j represents the columns of the array. If mix and miy are the spatial frequencies of the grating element (1,1) located at the top left corner of the grating array and η¾X and mjy are the spatial frequencies of the grating element (i,j) such that η¾X and mjy are the number of lines per unit length in the grating element along X and Y directions respectively, in the case of a plane wavefront incident on the grating array, in order to generate certain diffraction order focal spot array having NxN dimensions. Here mix , miy , and Am are real numbers. However, it is also possible to set the spatial frequencies asm ix= m Ix f°r a U ian d
= mly + {{i - l)N + (j - I)}Am or vice versa, to arrange all the focal spots along one horizontal or vertical line with Am representing the separation between two consecutive spots of a given order.

The spatial frequencies of the grating elements can be so defined such that focal spot arrays can be made to form arrays with any user defined number of rows and columns so long as the total number of elements in the array is N . In principle focal spots corresponding to any diffraction order will form a regular array or arrays in the unaberrated case. However, it is more convenient to choose the +1 diffraction order over the others because among all the diffraction orders, the +1 order will have the highest energy. The plane D in figure 3 comprises a regular grid of focal spots illustrated by the black dots, in the unaberrated case. In the presence of aberrations in the incident beam, such as a beam with wavefront W1 W2 , the focal spots get shifted, for instance, similar to the red dots as shown in figure 3. A digital camera such as a CCD or CMOS camera is kept at D to capture an image of the focal spot array. The shifts of the focal spots with respect to their reference positions, due to a plane wavefront, gives a measure of local slope values corresponding to the wavefront portions intercepted by the respective gratings.

In all the implementations of the systems as depicted in Figure 1, 2, 4, 5 and 6, as the film deposition starts, the topography of the reflecting surface on the substrate gets constantly modified. As a result, the wavefront of the beam incident on the grating array gets modified continuously. In one exemplary implementation, Po represents the wavefront before the start of deposition at a time instant %; Pi represents the wavefront due to added mass on the substrate during deposition at a time instant ti ; P2 at t2 and so on. The subsequent variation of the focal spot positions due to variation of the wavefronts can be read by the computer program which can be used to reconstruct the instantaneous incident wavefront. As the measurement starts from the moment when there is no deposition, hence, the sensor can provide a measure for both, surface profile and thickness, provided the measured area over the substrate is larger than the area over which deposition is taking place.

In one implementation, the configuration of the grating array facilitates dynamic switching between grating patterns in the programmable phase or amplitude mask. Thus instead of an array of gratings, a single grating or a hologram can be implemented such that the corresponding focal spot in the digital camera can be monitored whose size as well shape can provide the information regarding thickness variation of the sample globally all over the area or locally over a small area. Further programmable switching to grating array mode, generating a focal spot array with smaller number of rows or with just one row in the unaberrated case facilitates higher frame rate of the digital camera. Thus the proposed system will be able to make measurements more quickly making the measurement less susceptible to mechanical vibrations in the deposition system.

In yet another implementation, the same arrangement described above can also be used for semi-transparent samples, as the sensor can distinguish between reflections from the substrate and the top surface of the thin sample. The general principle of the technique discussed above is most likely applicable to any deposition system that provides the facility to direct a laser beam onto the sample and to receive the reflected beam coming out from the sample. However, the present invention can also be adapted and implemented to create a system for continuous in-situ monitoring and measuring of thin film thickness and its profile simultaneously in-situ during deposition in a pulsed laser deposition system ( PLD).

Reference is made to figure 4, wherein the pulsed laser deposition system, as an example is illustrated to simultaneously monitor both the surface profile and thickness of the thin film, according to all implementation of the present invention. In all implementation, the pulse laser deposition system may consists of a multiport chamber with the provision of evacuation and gas fill. A high power pulsed laser such as a second harmonic of Q switched Nd: YAG laser, is focused on to the target consisting of the material whose thin film is required to be deposited. The focusing of the laser results into the plasma formation of the target material which expands in vacuum or in presence of low pressure inert or the reactive gaseous medium and finally gets deposited on the substrate placed few centimeter away and parallel to the target. The remaining procedure to monitor surface profile and thickness measurement of the thin film in-situ during deposition is similar to the other implementations of the present invention, such as described with respect to figure 1 and figure 2.

Reference is made to figure 5, wherein a system to simultaneously monitor both the surface profile and thickness of the thin film is illustrated if the surface of the said substrate is non-planar, according to third implementation of the present invention.

In the third implementation of the invention, a part of the laser beam just before entering the view port of the thin film deposition system is taken out using a beam splitter BSI as seen in figure 5. This beam after reflections from mirrors MI and M2 and beam splitter BS2 gets incident on the programmable mask. The remaining procedure to monitor surface profile and thickness measurement of the thin film in-situ during deposition is similar to the first and second implementation of the present invention, as described with respect to figure 1 and figure 2. This additional beam path facilitates measuring the surface profile of the substrate in the case the surface is not perfectly flat.

Reference is made to figure 6, wherein a system to measure the surface profile and the thickness profile simultaneously or separately in a thin film deposition system by enhancing the sensitivity of the measurement is illustrated. In fourth implementation, the arrangement comprises a half waveplate, quarter waveplates and polarizing beam splitters to give rise to two beam paths, one from the grating array to generate the focal spot array and the other directly from the laser and the collimated beam that is made to incident twice on the substrate or the thin film before the beam incident on the wavefront sensor. The digital camera can image the focal spot corresponding to the beam coming directly from the laser and the focal spot coming from a specific grating element from the grating array. In this implementation, the camera either receives a focal spot array whose position can be used to measure the surface profile and thickness of the thin film or the overlapped focal spots corresponding to a beam coming directly from the laser and another beam coming from a specific grating element carrying the surface information from the substrate or the thin film for the measurement of thickness only.

In first, second and third implementation, a data processing module adapted to receive the said image from said image capturing means and configured to:
- measure at least one wavefront of said incident beam at one or more instants of time from said focal spot positions corresponding to at least one relative position of said array of focal spot before deposition and at any subsequent instants after deposition; and
- generate information corresponding to said surface profile and said thickness measurement simultaneously based on said wavefront measured.

In the fourth implementation of the invention, as shown in figure 6, the collimated laser beam passes through a half wave plate (λ/2) before getting incident on a polarizing beam splitter PBS I. PBSI transmits the p-polarized component which gets incident on the substrate or the thin film through a quarter wave plate (λ/4) and the view port. The reflected wavefront is relayed onto a plane mirror M 1 using the combination of lenses L3 and L4 such that the substrate and MI are conjugate to one another. The beam reflected by MI suffers one more reflection from the substrate or the thin film before it comes out through the viewport and the λ/4 plate. The light thus can be incident on PBSI as s-polarized and gets reflected towards L5 and h to be incident on the programmable mask. The lenses L5 and L6 ensure that the substrate and the mask plane are optically conjugate. The light diffracted by the grating array displayed on the programmable mask is again directed towards the PBS1. For certain liquid crystal spatial light modulator acting as the programmable mask the diffracted beam will be p-polarized. Else, another λ/4 plate can be used to make the diffracted beams p- polarized. The diffracted beams thus get transmitted by PBS1. A lens L can be used to focus the diffracted beams and thus isolate the required focal spots with the help of an iris diaphragm ID. These focal spots are imaged through a polarizer Pol on the digital camera using the lens L$. The same camera can also image the focal spot resulting from the s- polarized component of beam coming from the laser. This image can be positioned at a corner or near the edge of the camera. In one operation the programmable mask implements an array of gratings giving rise to an array of focal spots on the camera. As the beam getting incident on the grating array is reflected twice by the substrate or the thin film, the focal spot positions due to the grating array will be very much sensitive to the surface profile of the thin film. In another operation, the grating elements in the array can be sequentially displayed such that at an instant the camera receives two focal spots, one due to the s-polarized component from the laser and the other due to a particular grating element. The polarizer and the λ/2 plate can be oriented in such a way that the camera receives mutually parallel polarization component and the two focal spots have similar intensity. The spatial frequency of the grating element is changed in such a way that the two focal spots superimpose. Thus the camera can record the peak intensity which will be a function of the phase difference or relative path difference between the two beams. The path difference on the other hand is a function of the thickness of the thin film in a region specific to the grating element displayed. An extra optical path can be introduced into the path of the s-polarized component from the laser using the polarising beam splitters PBS2 and PBS3 and the plane mirrors M2 and M3, so that the two beams are mutually coherent. The intensity variation at the point of overlap can be used to extract the thickness of the thin film at the specific location as the deposition takes place. As different grating elements are displayed the thickness information over the entire area of the thin film can be obtained. This operation can provide the thickness profile of the thin film irrespective of the size of the measured area, provided between two consecutive frames the film deposited is not thicker than λ/4 (this is not a serious limitation as the deposition rate is usually of the order of -IOnm/minute or less for the majority cases).

In the fourth implementation said data processing module configured to receive image of said array of focal spot to measure the surface profile and thickness of the thin film by measuring relative position of said focal spot or receive an overlapped focal spots corresponding to said second laser beam path coming directly from the laser and said first laser beam path coming from a specific grating element carrying the surface information from said substrate for the measurement of thickness only.

In respect of all the implementations described above, the programmable phase or amplitude mask may optionally be implemented by using a spatial light modulator such as liquid crystal spatial light modulator, while the digital camera can be a CCD or a CMOS based camera. Further, the number of optical elements such as lens, mirror, and beam splitter shown in the above embodiments are the optimum numbers and it is very much possible to realize the above implementations with slight modification in the number of the optical elements.

In all implementation, the grating array in the wavefront-sensor device is implemented using a phase mask or an amplitude mask such as computer controllable liquid- crystal spatial-light modulator in conjunction with a digital camera.

In all implementation of the present invention, the system may require at least two view ports at specific locations for the monitoring surface profile and thickness.

In all the implementation of the present invention, the measured wavefront can be thereby communicated from the image capturing means to a data processing module for realtime monitoring of the surface profile and thickness measurement of the thin films. In all the implementation of the present invention, the focal spot shifts as obtained from the digital camera can be used in said data processing module and said data processing module configured to execute standard or the improved wavefront reconstruction algorithms and the like to obtain the phase profile corresponding to the beam under consideration

Some of the essential features of the present invention includes: a) Use of grating array based wavefront sensor in any thin film deposition system.
b) Use of a programmable spatial light modulator to implement grating array based wavefront sensor in any thin film deposition system.
c) Programmable switching between various grating patterns in the SLM used in any thin film deposition system.
d) Use of grating array that facilitates the highest possible frame rate in the digital camera associated with the wavefront sensor used in any thin film deposition system, e) Use of diffracted beams of + 1 order or any other order to measure the wavefront of a laser beam and hence the surface profile of the thin film.
f) Programmable switching between various grating patterns in the SLM used in any thin film deposition system to measure both the surface profile and thickness or only the thickness.
g) Online monitoring of the surface profile and the thickness simultaneously without any prior calibration, thus making it independent of the substrate and the deposition environment.
h) Online monitoring of the surface profile and the thickness simultaneously by making the beam incident on the wavefront sensor after getting reflected twice from the substrate or the thin film thereby increasing the sensitivity of the measurement.
i) Online measurement of the thickness of the thin film deposited at various locations in a sequential manner by displaying one grating element at a time and making the resulting beam overlap with a beam with a fixed optical path thereby observing resultant intensity at the overlapped point. j) Online monitoring of the surface profile and the thickness simultaneously of the thin film in a pulsed laser thin film deposition system after each and every pulse of the laser incident on the target,
k) The measurement of surface profile and thickness measurement relying on the temporal evolution of the surface profile such that the shifts in the focal spots in the camera corresponds to two different time instants.

Although implementations for system, apparatus and method for monitoring of surface profile and thickness measurement thereof have been described in language specific to structural features and/or methods, it is to be understood that the appended claims are not necessarily limited to the specific features or methods described. Rather, the specific features and methods are disclosed as examples of implementations for system, apparatus and method for monitoring of surface profile and thickness measurement.

## Claims

1. A system for real-time monitoring of surface profile and thickness measurement of at least one thin film on at least one thin film deposition unit, said system comprising:
at least one laser generating means to generate at least one laser beam, said laser beam being incident on at least one substrate in said thin film deposition unit and thereby being reflected;
at least one grating array based wavefront sensor to receive said reflected laser beam as an incident beam and thereby reflect at least one diffracted beam of at least one desired order, said diffracted beam isolated by at least one iris diaphragm;
at least two lenses to receive said diffracted beam and generate an array of focal spots at one or more position;
at least one image capturing means to capture the image of said focal spots corresponding to said position of said focal spots;
at least one data processing module adapted to receive said image from said image capturing means and configured to:
measure at least one wavefront of said incident beam at one or more instants of time from said focal spot positions corresponding to at least one relative position of said array of focal spot before deposition and at
any subsequent instants after deposition; and
generate at least one information corresponding to said surface profile and said thickness measurement simultaneously, provided the measured area over the substrate is larger than the area over which deposition is taking place, based on said wavefront measured.

2. The system as claimed in claim 1, wherein said system comprises at least two lenses to expand and collimate said laser beam before being incident on said substrate, wherein said sample is a substrate in said thin film deposition unit.

3. The system as claimed in claim 1 and 2, wherein said array of gratings in said wavefront sensor is implemented by a configurable and controllable light modulator.

4. The system as claimed in claim 3, wherein said light modulator is an amplitude or phase mask that is implemented using at least one selected from liquid crystal spatial light modulator or spatial light modulators.

5. The system as claimed in claim 4, wherein said system comprises a combination of at least two lenses positioned between said substrate and said amplitude or phase mask to conjugate at least two planes to one another.

6. The system as claimed in claim 5, wherein said two conjugate planes include a substrate plane and a phase mask plane.

7. The system as claimed in claim 1, wherein said diffracted beams of said order from said gratings are focused on said image capturing means using a combination of two lenses and an iris diaphragm, to form an array of focal spots.

8. The system as claimed in claim 7, wherein said image capturing means is a charge-coupled device or complementary metal-oxide semiconductor based digital camera.

9. The system as claimed in claim 1, wherein said grating array based wavefront sensor is a Zonal wavefront sensor.

10. The system as claimed in claim 1, wherein said information is communicated to at least one digital system for real-time monitoring of said surface profile and thickness measurement of said thin films.

11. The system as claimed in claim 1, wherein said information corresponding to said surface profile and said thickness measurement facilitates in-situ monitoring and measuring of said thin films thickness and said surface profile during deposition in a Pulsed Laser Deposition System.

12. The system as claimed in claim 1, wherein the at least one data processing module provides said information with respect to said surface profile in terms of a reconstructed wavefront of said incident beam or magnitudes of the aberration modes corresponding to an orthogonal basis function.

13. The system as claimed in 1, wherein the system comprises an arrangement of at least one first beam splitter, at least two mirrors and at least one second beam splitter to produce a replica of said laser beam prior to being incident on said substrate in said thin film deposition unit and thereby allowing measurement of said surface profile of said substrate in an event wherein said surface is uneven.

14. A method in a thin film deposition system for real-time monitoring of surface profile and thickness measurement simultaneously of at least one thin film, said method comprising:
generating, by one or more laser generating means, at least one laser beam and incident said laser beam on a substrate in a thin film deposition unit;
reflecting, by said substrate, said laser beam and thereby transmitted through at least two lenses and incident said transmitted laser beam on a grating array based wavefront sensor, as an input beam;
transmitting, by said grating array based wavefront sensor, at least one diffracted beam of at least one desired order to a combination of at least two lenses, at least one iris diaphragm to isolate the diffracted beam and at least one detector plane for generating an array of focal spots at one or more position;
capturing, by at least one image capturing means, an image of said focal spot for obtaining, by a data processing module, a wavefront of said laser beam;
determining, by said data processing module, said position of said focal spot for measuring wavefront of said input beam at one or more instant of time from said focal spot positions corresponding to at least one relative position of said array of focal spot before deposition and at any subsequent instants after deposition; and thereby
generating, by said data processing module, at least one information corresponding to said surface profile and said thickness measurement simultaneously provided the measured area over the substrate is larger than the area over which deposition is taking place, based on said wavefront measured.

15. The method as claimed in claim 14, said method further comprising:
producing a replica of said laser beam prior to being incident on said substrate in said thin film deposition unit by an arrangement of at least one first beam splitter, at least two mirror and at least one second beam splitter and thereby measuring said surface profile of said substrate in an event when said surface is uneven.

## Patentansprüche

1. Ein System zur Echtzeitüberwachung eines Oberflächenprofils und Dickenmessung mindestens einer Dünnschicht auf mindestens einer Dünnschichtabscheidungseinheit, wobei das System Folgendes beinhaltet:
mindestens ein Lasererzeugungsmittel zum Erzeugen mindestens eines Laserstrahls, wobei der Laserstrahl auf mindestens ein Substrat in der Dünnschichtabscheidungseinheit einfällt und dadurch reflektiert wird;
mindestens einen auf einer Gitteranordnung basierenden Wellenfrontsensor zum Empfangen des reflektierten Laserstrahls als einen einfallenden Strahl und dadurch Reflektieren mindestens eines gebeugten Strahls mindestens einer gewünschten Ordnung, wobei der gebeugte Strahl durch mindestens eine Irisblende isoliert wird;
mindestens zwei Linsen zum Empfangen des gebeugten Strahls und Erzeugen einer Anordnung von Brennflecken an einer oder mehreren Positionen;
mindestens ein Bilderfassungsmittel zum Erfassen des Bilds der Brennflecken entsprechend der Position der Brennflecken;
mindestens ein Datenverarbeitungsmodul, das zum Empfangen des Bilds von dem Bilderfassungsmittel angepasst ist und für Folgendes konfiguriert ist:
Messen mindestens einer Wellenfront des einfallenden Strahls zu einem oder mehreren Zeitpunkten aus den Brennfleckpositionen entsprechend mindestens einer relativen Position der Anordnung von Brennflecken vor der Abscheidung und zu beliebigen nachfolgenden Zeitpunkten nach der Abscheidung; und
gleichzeitiges Erzeugen mindestens einer dem Oberflächenprofil und der Dickenmessung entsprechenden Information basierend auf der gemessenen Wellenfront, vorausgesetzt, dass die über das Substrat gemessene Fläche größer ist als die Fläche, über die die Abscheidung stattfindet.

2. System gemäß Anspruch 1, wobei das System mindestens zwei Linsen beinhaltet, um den Laserstrahl vor dem Einfallen auf das Substrat zu weiten und zu bündeln, wobei die Probe ein Substrat in der Dünnschichtabscheidungseinheit ist.

3. System gemäß Anspruch 1 und 2, wobei die Anordnung von Gittern in dem Wellenfrontsensor durch einen konfigurierbaren und steuerbaren Lichtmodulator implementiert ist.

4. System gemäß Anspruch 3, wobei der Lichtmodulator eine Amplituden- oder Phasenmaske ist, die unter Verwendung mindestens eines aus räumlichem Flüssigkristall-Lichtmodulator oder räumlichen Lichtmodulatoren Ausgewählten implementiert ist.

5. System gemäß Anspruch 4, wobei das System eine Kombination von mindestens zwei Linsen beinhaltet, die zwischen dem Substrat und der Amplituden- oder Phasenmaske positioniert sind, um mindestens zwei Ebenen zueinander zu konjugieren.

6. System gemäß Anspruch 5, wobei die zwei konjugierten Ebenen eine Substratebene und eine Phasenmaskenebene umfassen.

7. System gemäß Anspruch 1, wobei die gebeugten Strahlen der Ordnung von den Gittern unter Verwendung einer Kombination von zwei Linsen und einer Irisblende auf das Bilderfassungsmittel fokussiert werden, um eine Anordnung von Brennflecken zu bilden.

8. System gemäß Anspruch 7, wobei das Bilderfassungsmittel eine auf ladungsgekoppelter Schaltung oder komplementärem Metalloxidhalbleiter basierende digitale Kamera ist.

9. System gemäß Anspruch 1, wobei der auf einer Gitteranordnung basierende Wellenfrontsensor ein zonaler Wellenfrontsensor ist.

10. System gemäß Anspruch 1, wobei die Information mindestens einem digitalen System zur Echtzeitüberwachung des Oberflächenprofils und Dickenmessung der Dünnschichten vermittelt wird.

11. System gemäß Anspruch 1, wobei die dem Oberflächenprofil und der Dickenmessung entsprechende Information das In-situ-Überwachen und -Messen der Dünnschichtdicke und des Oberflächenprofils während der Abscheidung in einem System mit gepulster Laserabscheidung ermöglicht.

12. System gemäß Anspruch 1, wobei das mindestens eine Datenverarbeitungsmodul die Information mit Bezug auf das Oberflächenprofil in Form einer rekonstruierten Wellenfront des einfallenden Strahls oder von Größen der Aberrationsmoden entsprechend einer orthogonalen Basisfunktion bereitstellt.

13. System gemäß Anspruch 1, wobei das System eine Gruppierung von mindestens einem ersten Strahlteiler, mindestens zwei Spiegeln und mindestens einem zweiten Strahlteiler beinhaltet, um eine Kopie des Laserstrahls vordem Einfallen auf das Substrat in der Dünnschichtabscheidungseinheit zu produzieren und dadurch die Messung des Oberflächenprofils des Substrats zu gestatten, wenn die Oberfläche uneben ist.

14. Ein Verfahren in einem Dünnschichtabscheidungssystem zur gleichzeitigen Echtzeitüberwachung eines Oberflächenprofils und Dickenmessung mindestens einer Dünnschicht, wobei das Verfahren Folgendes beinhaltet:
Erzeugen, durch ein oder mehrere Lasererzeugungsmittel, mindestens eines Laserstrahls und Einfallenlassen des Laserstrahls auf ein Substrat in einer Dünnschichtabscheidungseinheit;
Reflektieren, durch das Substrat, des Laserstrahls und dadurch Übertragen durch mindestens zwei Linsen und Einfallenlassen des übertragenen Laserstrahls als Eingangsstrahl auf einen auf einer Gitteranordnung basierenden Wellenfrontsensor;
Übertragen, durch den auf einer Gitteranordnung basierenden Wellenfrontsensor, mindestens eines gebeugten Strahls mindestens einer gewünschten Ordnung an eine Kombination von mindestens zwei Linsen, mindestens einer Irisblende zum Isolieren des gebeugten Strahls und mindestens einer Detektorebene zum Erzeugen einer Anordnung von Brennflecken an einer oder mehreren Positionen;
Erfassen, durch mindestens ein Bilderfassungsmittel, eines Bilds der Brennflecken zum Erhalten, durch ein Datenverarbeitungsmodul, einer Wellenfront des Laserstrahls;
Bestimmen, durch das Datenverarbeitungsmodul, der Position der Brennflecken zum Messen der Wellenfront des Eingangsstrahls zu einem oder mehreren Zeitpunkten aus den Brennfleckpositionen entsprechend mindestens einer relativen Position der Anordnung von Brennflecken vor der Abscheidung und zu beliebigen nachfolgenden Zeitpunkten nach der Abscheidung; und dadurch
gleichzeitiges Erzeugen, durch das Datenverarbeitungsmodul, mindestens einer dem Oberflächenprofil und der Dickenmessung entsprechenden Information basierend auf der gemessenen Wellenfront, vorausgesetzt, dass die über das Substrat gemessene Fläche größer ist als die Fläche, über die die Abscheidung stattfindet.

15. Verfahren gemäß Anspruch 14, wobei das Verfahren ferner Folgendes beinhaltet:
Produzieren einer Kopie des Laserstrahls vor dem Einfallen auf das Substrat in der Dünnschichtabscheidungseinheit durch eine Gruppierung von mindestens einem ersten Strahlteiler, mindestens zwei Spiegeln und mindestens einem zweiten Strahlteiler und dadurch Messen des Oberflächenprofils des Substrats, wenn die Oberfläche uneben ist.

## Revendications

1. Un système pour une surveillance en temps réel d'un profil de surface et une mesure de l'épaisseur d'au moins un film mince sur au moins une unité de dépôt de film mince, ledit système comprenant :
au moins un moyen de génération de laser afin de générer au moins un faisceau laser, ledit faisceau laser étant incident sur au moins un substrat dans ladite unité de dépôt de film mince et étant de ce fait réfléchi ;
au moins un capteur de front d'onde basé sur un réseau en grille pour recevoir ledit faisceau laser réfléchi comme un faisceau incident et de ce fait réfléchir au moins un faisceau diffracté d'au moins un ordre souhaité, ledit faisceau diffracté étant isolé par au moins un diaphragme-iris ;
au moins deux lentilles pour recevoir ledit faisceau diffracté et générer un réseau de taches focales au niveau d'une ou de plusieurs positions ;
au moins un moyen de capture d'images pour capturer l'image desdites taches focales correspondant à ladite position desdites taches focales ;
au moins un module de traitement de données conçu pour recevoir ladite image provenant dudit moyen de capture d'images et configuré pour :
mesurer au moins un front d'onde dudit faisceau incident à un ou plusieurs instants dans le temps à partir desdites positions de taches focales correspondant à au moins une position relative dudit réseau de taches focales avant le dépôt et à tous instants subséquents après le dépôt ; et
générer au moins un élément d'information correspondant audit profil de surface et à ladite mesure d'épaisseur en simultanéité, à condition que l'aire mesurée sur le substrat soit plus grande que l'aire sur laquelle le dépôt a lieu, sur la base dudit front d'onde mesuré.

2. Le système tel que revendiqué dans la revendication 1, ledit système comprenant au moins deux lentilles pour élargir et collimater ledit faisceau laser avant qu'il ne soit incident sur ledit substrat, dans lequel ledit échantillon est un substrat dans ladite unité de dépôt de film mince.

3. Le système tel que revendiqué dans la revendication 1 et la revendication 2, dans lequel ledit réseau de grilles dans ledit capteur de front d'onde est mis en œuvre par un modulateur de lumière configurable et commandable.

4. Le système tel que revendiqué dans la revendication 3, dans lequel ledit modulateur de lumière est un masque d'amplitude ou de phase qui est mis en œuvre à l'aide d'au moins un modulateur sélectionné parmi un modulateur spatial de lumière à cristaux liquides et des modulateurs spatiaux de lumière.

5. Le système tel que revendiqué dans la revendication 4, ledit système comprenant une combinaison d'au moins deux lentilles positionnées entre ledit substrat et ledit masque d'amplitude ou de phase pour conjuguer au moins deux plans l'un avec l'autre.

6. Le système tel que revendiqué dans la revendication 5, dans lequel lesdits deux plans conjugués incluent un plan de substrat et un plan de masque de phase.

7. Le système tel que revendiqué dans la revendication 1, dans lequel lesdits faisceaux diffractés dudit ordre provenant desdites grilles sont focalisés sur ledit moyen de capture d'images à l'aide d'une combinaison de deux lentilles et d'un diaphragme-iris, pour former un réseau de taches focales.

8. Le système tel que revendiqué dans la revendication 7, dans lequel ledit moyen de capture d'images est un dispositif à couplage de charges ou une caméra numérique à base de semi-conducteur d'oxyde de métal complémentaire.

9. Le système tel que revendiqué dans la revendication 1, dans lequel ledit capteur de front d'onde basé sur un réseau en grille est un capteur de front d'onde zonal.

10. Le système tel que revendiqué dans la revendication 1, dans lequel lesdits éléments d'information sont communiqués à au moins un système numérique pour une surveillance en temps réel dudit profil de surface et la mesure d'épaisseur desdits films minces.

11. Le système tel que revendiqué dans la revendication 1, dans lequel lesdits éléments d'information correspondant audit profil de surface et à ladite mesure d'épaisseur favorisent une surveillance et une mesure in situ de ladite épaisseur des films minces et dudit profil de surface au cours du dépôt dans un système de dépôt à laser pulsé.

12. Le système tel que revendiqué dans la revendication 1, dans lequel l'au moins un module de traitement de données fournit lesdits éléments d'information concernant ledit profil de surface en termes d'un front d'onde reconstruit dudit faisceau incident ou d'amplitudes des modes d'aberration correspondant à une fonction de base orthogonale.

13. Le système tel que revendiqué dans la revendication 1, le système comprenant un agencement d'au moins un premier diviseur de faisceau, d'au moins deux miroirs et d'au moins un deuxième diviseur de faisceau pour produire une réplique dudit faisceau laser avant qu'il ne soit incident sur ledit substrat dans ladite unité de dépôt de film mince et de ce fait permettre une mesure dudit profil de surface dudit substrat dans un cas dans lequel ladite surface est inégale.

14. Un procédé dans un système de dépôt de film mince pour une surveillance en temps réel d'un profil de surface et une mesure d'épaisseur en simultanéité d'au moins un film mince, ledit procédé comprenant :
la génération, par un ou plusieurs moyens de génération de laser, d'au moins un faisceau laser et le fait de rendre incident ledit faisceau laser sur un substrat dans une unité de dépôt de film mince ;
le réfléchissement, par ledit substrat, dudit faisceau laser et de ce fait sa transmission à travers au moins deux lentilles et le fait de rendre incident ledit faisceau laser transmis sur un capteur de front d'onde basé sur un réseau en grille, comme faisceau d'entrée ;
la transmission, par ledit capteur de front d'onde basé sur un réseau en grille, d'au moins un faisceau diffracté d'au moins un ordre souhaité à une combinaison d'au moins deux lentilles, d'au moins un diaphragme-iris pour isoler le faisceau diffracté et d'au moins un plan de détecteur pour générer un réseau de taches focales à une ou plusieurs positions ;
la capture, par au moins un moyen de capture d'images, d'une image desdites taches focales pour obtenir, par un module de traitement de données, un front d'onde dudit faisceau laser ;
la détermination, par ledit module de traitement de données, de ladite position desdites taches focales pour mesurer le front d'onde dudit faisceau d'entrée à un ou plusieurs instants dans le temps à partir desdites positions de taches focales correspondant à au moins une position relative dudit réseau de taches focales avant le dépôt et à tous instants subséquents après le dépôt ; et de ce fait
la génération, par ledit module de traitement de données, d'au moins un élément d'information correspondant audit profil de surface et à ladite mesure d'épaisseur en simultanéité à condition que l'aire mesurée sur le substrat soit plus grande que l'aire sur laquelle le dépôt a lieu, sur la base dudit front d'onde mesuré.

15. Le procédé tel que revendiqué dans la revendication 14, ledit procédé comprenant en outre :
la production d'une réplique dudit faisceau laser avant qu'il ne soit incident sur ledit substrat dans ladite unité de dépôt de film mince par un agencement d'au moins un premier diviseur de faisceau, d'au moins deux miroirs et d'au moins un deuxième diviseur de faisceau et de ce fait la mesure dudit profil de surface dudit substrat dans un cas où ladite surface est inégale.
